# EUROPEAN PATENT SPECIFICATION

(11) **EP 2 113 493 B1**
(45) Date of publication and mention of the grant of the patent: **27.02.2019**
(21) Application number: 09005956.9
(22) Date of filing: 29.04.2009
(51) Int. Cl.: C03C 17/22, C03C 17/00

(54) **Alkaline earth fluoride coatings deposited via combustion deposition**
Erdalkali-Fluorid-Beschichtungen mittels Abscheidung durch Verbrennung
Revêtements de fluorure alcalinoterreux déposé via un dépôt de combustion

(30) Priority: 30.04.2008 US 149396
(43) Date of publication of application: 04.11.2009
(73) Proprietor: Guardian Glass, LLC, Auburn Hills MI 48326 (US)
(72) Inventor: Remington, Michael P., Jr., Toledo, Ohio 43615 (US)
(74) Representative: Hess, Peter K. G.

(56) References cited:
- DE-A1- 10 206 330
- US-A- 5 165 960
- PULKER, H.K.: "Coatings on Glass" 1984, ELSEVIER , AMSTERDAM - OXFORD - NEW YORK - TOKYO , XP002540775 Chapter 9.3.1. Single-Layer Antireflection Coating (pages 399-401; table 1)
- HUNT A T ET AL: "COMBUSTION CHEMICAL VAPOR DEPOSITION: A NOVEL THIN-FILM DEPOSITION TECHNIQUE" APPLIED PHYSICS LETTERS, AIP, AMERICAN INSTITUTE OF PHYSICS, MELVILLE, NY, US, vol. 63, no. 2, 12 July 1993 (1993-07-12), pages 266-268, XP000382542 ISSN: 0003-6951
- STROBEL R ET AL: "Flame aerosol synthesis of smart nanostructured materials" JOURNAL OF MATERIALS CHEMISTRY,, vol. 17, 25 September 2007 (2007-09-25), pages 4743-4756, XP002540713
- R.N. GRASS; W.J. STARK: "Flame synthesis of calcium-, strontium, barium fluoride nanoparticles and sodium chloride" CHEM. COMMUN., 2005, pages 1767-1769, XP002540774
- SARHANGI A ET AL: "CHEMICAL VAPOR DEPOSITING OF METAL FLUORIDES" JOURNAL OF VACUUM SCIENCE AND TECHNOLOGY: PART A, AVS /AIP, MELVILLE, NY., US, vol. 10, no. 4 PT II, 1 July 1992 (1992-07-01), pages 1514-1517, XP000296242 ISSN: 0734-2101

## Description

### FIELD OF THE INVENTION

Certain example embodiments of this invention relate to the deposition of metal fluoride coatings onto substrates via combustion deposition. More particularly, certain example embodiments relate to the combustion deposition depositing of alkaline earth fluoride inclusive coatings from a metal inclusive organic precursor and a fluorinating reagent, or from a single-source precursor. In certain example embodiments, the fluorinating reagent may be an organic source or an inorganic source. In certain example embodiments, the alkaline earth fluoride inclusive coating may be a magnesium fluoride (e.g., MgF₂ or other suitable stoichiometry) inclusive coating, although other Group 2 metals may be used in place of magnesium. In certain example embodiments, the alkaline earth fluoride inclusive coating may be an anti-reflective (AR) coating.

### BACKGROUND AND SUMMARY OF EXAMPLE EMBODIMENTS OF THE INVENTION

Combustion chemical vapor deposition (combustion CVD) is a relatively new technique for the growth of coatings. Combustion CVD is described, for example, in U.S. Patent Nos. 5,652,021; 5,858,465; and 6,013,318.

Conventionally, in combustion CVD, precursors are dissolved in a flammable solvent and the solution is delivered to the burner where it is ignited to give a flame. Such precursors may be vapor or liquid and fed to a self-sustaining flame or used as the fuel source. A substrate is then passed under the flame to deposit a coating.

Document DE 10206330 A1 discloses a method for depositing a ceramic layer on a substrate. Therefore, the material is deposited out of a flame. The synthesis of the material is performed by pyrolysis of suitable substances in the flame zone. The disclosed method is applied for functional layers in light techniques, however the method can also be applied to other functional materials like conductible oxide layers, high temperature superconductors, dielectric, piezoelectric, ferroelectric or magnetic substances or other layers with special mechanical, optical or chemical properties.

Document XP 002540713 discloses processes for flame aerosol synthesis of nanostructured materials. It is disclosed that the biggest application of flame-made films is in the manufacture of optical fibers for telecommunications by flame synthesis and deposition of doped-silica particles having closely controlled refractive index for light transmission with minimal losses over long distances. Today these are commercial processes named combustion chemical vapor deposition (CCVD), which is an extension of the usual CVD process. For example Fig. 8 of XP 002540713 shows a schematic of flame deposition processes. Sr, Ca and Ba fluorides were made by spray pyrolysis processes using organometallic precursors for the metals and hexafluorobenzene as a fluorine source, wherein pure SF₂ and BaF₂ were obtained.

Document XP 000296242 relates to chemical vapor depositing of metal fluorides. It is disclosed that depositing metal fluorides from M(hfa)*ₓ* (M = metal, hfa = hexafluoroacetylacetonate) avoids the need to employ halogenating agents such as HF, F₂, NF₂ and thereby simplifies the vapor deposition process by permitting the use of a single reagent rather than two reagents. In particular, this method is very useful for depositing highly pure fluorides. Furthermore, the chemical vapour desposition (CVD) of BeF₂ and BeF₂ - AlF₃ glasses using M(hfa)*ₓ* as only source compound are described.

There are several advantages of combustion CVD over traditional pyrolytic deposition techniques (such as CVD, spray and sol-.gel, etc.). One advantage is that the energy required for the deposition is provided by the flame. Another advantage is that combustion CVD techniques do not necessarily require volatile precursors. If a solution of the precursor can be atomized/nebulized sufficiently (e.g., to produce droplets and/or particles of sufficiently small size), the atomized solution will behave essentially as a gas and can be transferred to the flame without requiring an appreciable vapor pressure from the precursor of interest.

It will be appreciated that combustion deposition techniques may be used to deposit metal oxide coatings (e.g., single-layer anti-reflective coatings) on glass substrates, for example, to alter the optical and other properties of the glass substrates (e.g., to increase visible transmission). To this end, conventional combustion deposition techniques were used by the inventor of the instant application to deposit a single layer anti-reflective (SLAR) film of silicon oxide (e.g., SiO₂ or other suitable stoichiometry) on a glass substrate. The attempt sought to achieve an increase in light transmission in the visible spectrum (e.g., wavelengths of from about 400-700 nm) over clear float glass with an application of the film on one or both sides of a glass substrate. In addition, increases in light transmission for wavelengths greater the 700 nm are also achievable and also may be desirable for certain product applications, such as, for example, photovoltaic solar cells. The clear float glass used in connection with the description herein is a low-iron glass known as "Extra Clear," which has a visible transmission typically in the range of 90.3% to about 91.0%. Of course, the examples described herein are not limited to this particular type of glass, or any glass with this particular visible transmission.

The combustion deposition development work was performed using a conventional linear burner. As is conventional, the linear burner was fueled by a premixed combustion gas comprising propane and air. It is, of course, possible to use other combustion gases such as, for example, natural gas, butane, etc. The standard operating window for the linear burner involves air flow rates of between about 150 and 300 standard liters per minute (SLM), with air-to-propane ratios of about 15 to 25. Successful coatings require controlling the burner-to-lite distance to between about 5-50 mm when a linear burner is used.

Typical process conditions for successful films used a burner air flow of about 225 SLM, an air-to-propane ratio of about 19, a burner-to-lite distance of 35 mm, and a glass substrate velocity of about 50 mm/sec.

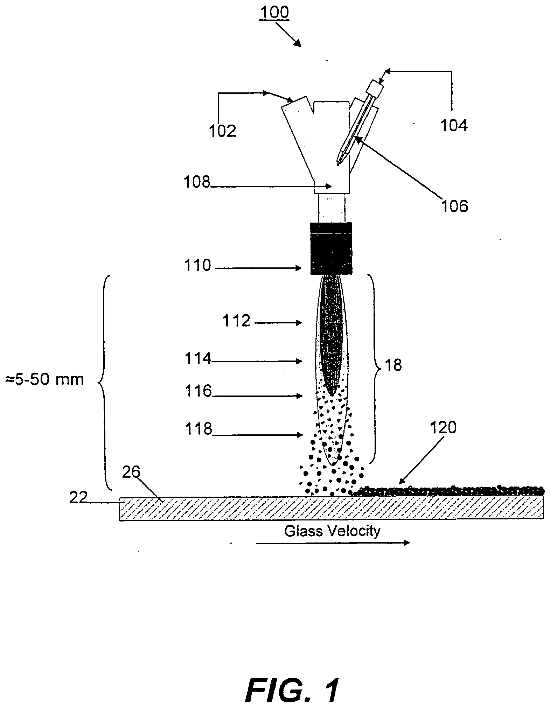

Fig. 1 is a simplified view of an apparatus 100 including a linear burner used to carry out combustion deposition. A combustion gas 102 (e.g., a propane air combustion gas) is fed into the apparatus 100, as is a suitable precursor 104 (e.g., via insertion mechanism 106, examples of which are discussed in greater detail below). Precursor nebulization (108) and at least partial precursor evaporation (110) occur within the apparatus 100 and also may occur external to the apparatus 100, as well. The precursor could also have been delivered as a vapor, thereby reducing or even eliminating the need for nebulization The flame 18 may be thought of as including multiple areas. Such areas correspond to chemical reaction area 112 (e.g., where reduction, oxidation, and/or the like may occur), nucleation area 114, coagulation area 116, and agglomeration area 118. Of course, it will be appreciated that such example areas are not discrete and that one or more of the above processes may begin, continue, and/or end throughout one or more of the other areas.

Particulate matter begins forming within the flame 18 and moves downward towards the surface 26 of the substrate 22 to be coated, resulting in film growth 120. As will be appreciated from Fig. 1, the combusted material comprises non-vaporized material (e.g., particulate matter), which is also at least partially in particulate form when coming into contact with the substrate 22. To deposit the coating, the substrate 22 may be moved (e.g., in the direction of the velocity vector). Of course, it will be appreciated that the present invention is not limited to any particular velocity vector, and that other example embodiments may involve the use of multiple apparatuses 100 for coating different portions of the substrate 22, may involve moving a single apparatus 100 while keeping the substrate in a fixed position, etc. The burner 110 is about 5-50 mm from the surface 26 of the substrate 22 to be coated.

Using the above techniques, the inventor of the instant application was able to produce coatings that provided a transmission gain of 1.96% or 1.96 percentage points over the visible spectrum when coated on a single side of clear float glass. The transmission gain may be attributable in part to some combination of surface roughness increases and air incorporation in the film that yields a lower effective index of refraction.

Based in part on the successful deposition of metal oxide coatings on glass substrates, the inventor of the instant application realized that it would be advantageous to deposit alkaline earth fluorides including, for example, magnesium fluoride coatings (e.g., MgF₂ or other suitable stoichiometry). Indeed, the deposition of magnesium fluoride coatings via combustion deposition would be advantageous, as magnesium fluoride is a prototypical material for single-layer anti-reflective (SLAR) coatings, owing to its low index of refraction. The index of refraction of bulk density (e.g., no or substantially no air incorporation) magnesium fluoride is nominally about 1.38. Magnesium fluoride (e.g., MgF2 or other suitable stoichiometry) is used for its inherent low refractive index and thus is used in anti-reflective coatings.

Thus, it will be appreciated that combustion deposition depositing alkaline earth fluorides including, for example, magnesium fluoride coatings, would be advantageous (e.g., in SLAR coatings).

At least one prior attempt has been used to generate alkaline earth fluoride nano-particles. In this attempt, Ca-, Sr-, and barium fluoride nano-particles were generated by flame spray pyrolysis of the corresponding metal organic precursor with hexafluorobenzene (see Grass, Robert N. and Wendelin J. Stark. "Flame synthesis of calcium-, strontium, barium fluoride nanoparticles and sodium chloride." Chem. Commun., 2005, pp. 1767-69.). The metal organic precursors used were the 2-ethylhexanoate salts of the alkaline earth metal. These precursors were synthesized by dissolving Ca(OH)₂, strontium acetate, or barium acetate in 2-ethylhexanoic acid. The nano-particles were collected on glass fiber filters placed above the flame. However, the possibility of depositing coatings (as opposed to generating bulk powders of nano-particles) does not appear to have been contemplated. Furthermore, the inventor of the instant application is not aware of any successful techniques for depositing alkaline earth metal fluoride coatings via combustion deposition.

Nevertheless, as noted above, the inventor of the instant application has recognized that the deposition of alkaline earth metal fluoride coatings via combustion deposition including, for example, the deposition of magnesium fluoride (e.g., MgF₂ or other suitable stoichiometry), calcium fluoride (e.g., CaF₂ or other suitable stoichiometry), strontium fluoride (e.g., SrF₂ or other suitable stoichiometry), and barium fluoride (e.g., BaF₂ or other suitable stoichiometry), would be advantageous. As such, it will be appreciated that there is a need in the art for viable atmospheric deposition routes to alkaline earth fluoride coatings, particularly magnesium fluoride (e.g., MgF₂ or other suitable stoichiometry) inclusive coatings, using combustion deposition.

In certain example embodiments, a method of making a coated article including a combustion deposition deposited coating is provided. A glass substrate having at least one surface to be coated is provided. A single-source precursor to be combusted by a flame is introduced. The single-source precursor is alkaline earth metal and fluorine inclusive. At least a portion of the precursor is combusted to form a combusted material. The combusted material comprises non-vaporized material. The glass substrate is provided in an area so that the glass substrate is heated sufficiently to allow the combusted material to form the coating, directly or indirectly, on the glass substrate. The coating is a metal fluoride coating.

In certain examples, a coated article is provided. The coated article comprises a substrate and a combustion deposition deposited alkaline earth metal fluoride coating supported by the substrate. The alkaline earth metal fluoride coating includes at least one of magnesium, calcium, strontium, and barium. The coating is a single-layer anti-reflective coating.

The features, aspects, advantages, and example embodiments described herein may be combined to realize yet further embodiments.

### BRIEF DESCRIPTION OF THE DRAWINGS

These and other features and advantages may be better and more completely understood by reference to the following detailed description of exemplary illustrative embodiments in conjunction with the drawings, of which:
FIGURE 1 is a simplified view of an apparatus including a linear burner used to carry out combustion deposition;
FIGURE 2a is a simplified view of an illustrative burner system used to carry out combustion deposition in accordance with an example embodiment;
FIGURE 2b is a simplified view of another illustrative burner system used to carry out combustion deposition in accordance with an example embodiment;
FIGURE 3a is an illustrative flowchart illustrating a process for depositing a metal fluoride coating on a glass substrate using combustion deposition in accordance with an example embodiment; and
FIGURE 3b is an illustrative flowchart illustrating another process for depositing a metal fluoride coating on a glass substrate using combustion deposition in accordance with an example embodiment.

### DETAILED DESCRIPTION OF EXAMPLE EMBODIMENTS OF THE INVENTION

In certain example embodiments, a method of making a coated article including a combustion deposition deposited coating is provided. A glass substrate having at least one surface to be coated is provided. A single-source precursor to be combusted by a flame is introduced. The single-source precursor is alkaline earth metal and fluorine inclusive. At least a portion of the precursor is combusted to form a combusted material. The combusted material comprises non-vaporized material. The glass substrate is provided in an area so that the glass substrate is heated sufficiently to allow the combusted material to form the coating, directly or indirectly, on the glass substrate. The coating is a metal fluoride coating.

In certain examples, a coated article is provided. The coated article comprises a substrate and a combustion deposition deposited alkaline earth metal fluoride coating supported by the substrate. The alkaline earth metal fluoride coating includes at least one of magnesium, calcium, strontium, and barium. The coating is a single-layer anti-reflective coating.

Certain example embodiments provide atmospheric deposition routes to alkaline earth fluoride coatings including, for example, magnesium fluoride (e.g., MgF₂ or other suitable stoichiometry) inclusive coatings, using combustion deposition. In certain example embodiments, a metal inclusive precursor and a fluorinating reagent may be used in the combustion deposition coating of alkaline earth fluorides. The metal inclusive precursor may be a metal inclusive organic precursor including, for example:
- [Me(OR)₂]ₓ, where Me is a metal chosen from Group 2 of the periodic table and R is a saturated organic group containing 1 to 5 carbon atoms;
- Metal alkoxyalkoxide or [Me(OROR')₂];
- Metal acetoacetonate or Me(acac)₂;
- Metal alkanoates or Me(OOCR)₂ including, for example, methacrylate, 2-ethylhexanoate, and/or the like; and/or
- Fluorinated acetoacetonate or Me(acac^{F})₂ including, for example, tri- or hexafluoropentanedionates.
It will be appreciated that any suitable stoichiometries of any of the above metal inclusive organic precursors may be used.

Suitable fluorinating reagents may be organic or inorganic fluorinating reagents. Suitable organic fluorinating reagents include, for example:
- Hexafluorobenzene (C₆F₆);
- C₇H₅F₃ (e.g., as C₆H₅CF₃ or C₆H₂)F₃CH₃);
- Trifluoro acetic acid (CF₃COOH);
- Trifluoro acetic anhydride;
- Other fluourinated carboxylic acids; and/or
- Fluorinated alcohols such as, for example, (F₃C)₃COH.
Suitable inorganic fluorinating reagents include, for example, NF₃ and SF₆. It will be appreciated that any suitable stoichiometries of any of the above organic or inorganic fluorinating reagents may be used.

Organic based fluorinating agents may generate carbon dioxide and water in the combustion zone. By contrast, inorganic sources of fluorine may generate NOₓ and SOₓ emissions in the combustion zone. Such NOₓ and SOₓ emissions may combine with water produced from the combustion, thereby contributing to a corrosive environment. Thus, the use of an organic fluorinating agent may be advantageous in certain example implementations, in that its incorporation may help to provide for a less corrosive and more environmentally friendly environment.

In certain example embodiments, metal fluoride coatings may be formed from single-source precursors rather than using a metal inclusive precursor and a separate fluorinating reagent. Suitable single-source precursors include, for example, fluorinated acetoacetonates or Me(acac^{F})₂ including, for example, tri- or hexafluoropentanedionates, as well as fluorinated metal alkoxides, alkanoates, and alkoxyalkoxides.

The forces behind these reactions are related to the affinity of Group 2 metals for fluorine and the corresponding lattice energy of forming the crystalline salt.

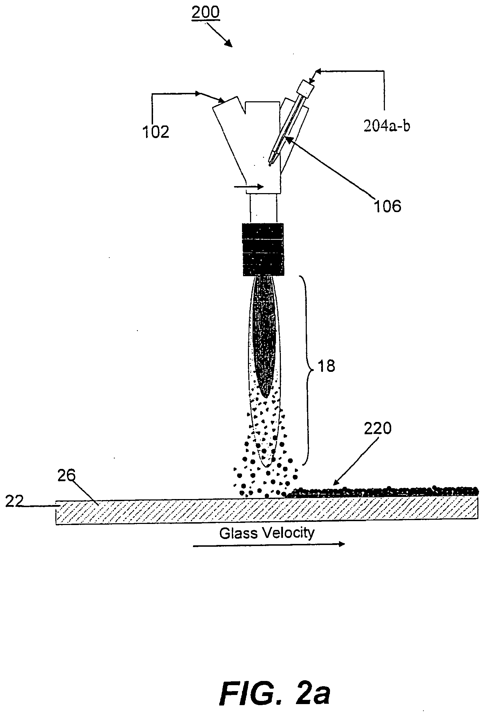

Fig. 2a is a simplified view of an illustrative burner system 200 used to carry out combustion deposition in accordance with an example which is not claimed. Fig. 2a is similar to Fig. 1, except that a metal organic precursor 204a and a fluorinating reagent 204b are introduced to the combustion gas stream 102 via one or more insertion mechanisms 106. The precursor 204a and/or the reagent 204b may be introduced into the combustion gas stream 106 in vapor, atomized liquid, and/or atomized solution form(s). For example, they may be introduced in a vapor state via a bubbler, as large particle droplets via an injector, and/or as small particle droplets via a nebulizer. Also, the precursor 204a and/or the reagent 204b need not be introduced to the combustion gas stream 106 in the same form, e.g., when separate insertion mechanisms 106 are provided.

As noted above, the metal organic precursor 204a and the fluorinating reagent 204b may be added to the combustion gas stream 102 using the same or different insertion mechanisms. For example, they may be added using a single insertion mechanism at substantially the same time in certain example embodiments when they are mixed together before insertion. In certain example embodiments when the metal organic precursor 204a and the fluorinating reagent 204b are not premixed, they may be added to the combustion gas stream 102 at substantially the same time through the same or separate insertion mechanisms. When multiple insertion mechanisms 106 are implemented, they may be the same or different insertion system(s), and/or they may be provided at the same or different location(s).

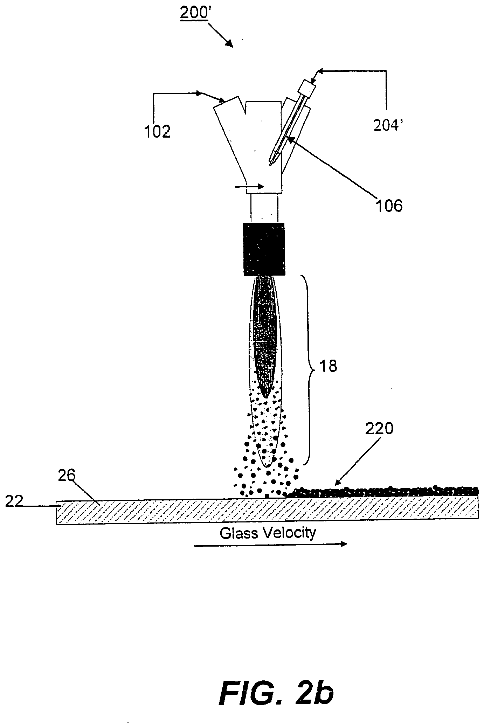

Fig. 2b is a simplified view of another illustrative burner system 200' used to carry out combustion deposition in accordance with an example embodiment. The burner system 200' of Fig. 2b is like the burner system 200 of Fig. 2a, except that the burner system 200' of Fig. 2b is arranged to add a single-source precursor 204' to the combustion gas stream 102 via a single insertion mechanism 106 in forming the coating.

The precursor 204a and the reagent 204b in Fig. 2a, and the single source precursor 204' in Fig. 2b, are selected so that, when combusted by the flame 18, a combusted material comprising at least some non-vaporized material (e.g., particulate matter) is formed. Precursors, reagents, and/or single-source precursors may be selected from the exemplary lists provided above, although it is possible to use precursors, reagents, and/or single-source precursors not in the example lists provided above. The combusted material, in turn, is deposited, directly or indirectly, on the surface to be coated 26 of the substrate 22, so as to form the coating 220.

While the coating 220 may be said to be "on" or "supported by" substrate 22 (directly or indirectly), other layer(s) may be provided therebetween. Thus, for example, the coating 220 may be considered "on" and "supported by" the substrate 22 even if other layer(s) are provided between growth 220a and substrate 22. Moreover, certain growths or layers of coating 220 may be removed in certain embodiments, while others may be added in other embodiments of this invention without departing from the overall spirit of certain embodiments of this invention.

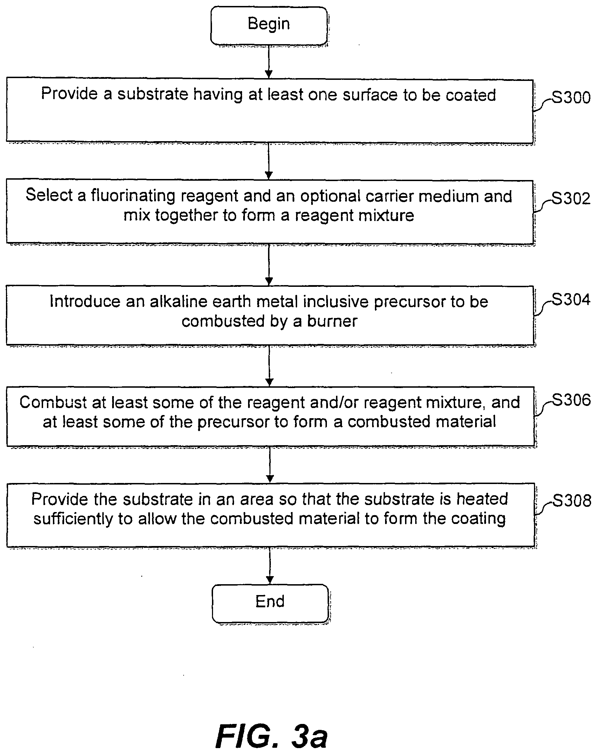

Fig. 3a is an illustrative flowchart illustrating a process for depositing a metal fluoride coating on a glass substrate using combustion deposition in accordance with an example that is not claimed. In step S300, a substrate (e.g., a glass substrate) having at least one surface to be coated is provided. A fluorinating reagent and an optional carrier medium are selected and mixed together to form a reagent mixture in step S302. The reagent is selected so that at least a portion of the reagent forms the coating. The fluorinating reagent may be an organic fluorinating reagent or an inorganic fluorinating reagent. An alkaline earth metal inclusive precursor to be combusted using a burner is introduced in step S304. In step S306, at least a portion of the fluorinating reagent and/or reagent mixture, and at least a portion of the precursor are combusted, thereby forming a combusted material. The precursor and the fluorinating reagent and/or reagent mixture may be introduced by a number of means. For example, the precursor, fluorinating reagent, and/or reagent mixture may be introduced in a vapor state via a bubbler, as large particle droplets via an injector, and/or as small particle droplets via a nebulizer. Also, the precursor, fluorinating reagent, and/or reagent mixture may be injected into the combustion stream, for example. In step S308, the substrate is provided in an area so that the substrate is heated sufficiently to allow the combusted materials to produce growths, directly or indirectly, on the substrate when forming the coating. The combusted material may include at least some non-vaporized material (e.g., at least some particulate matter).

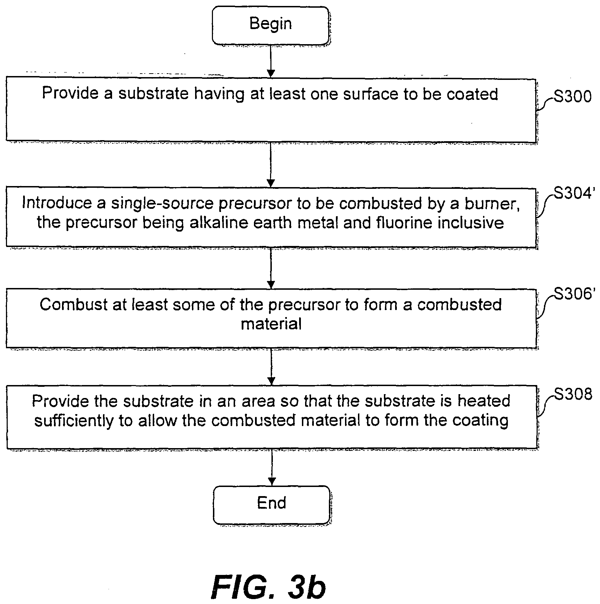

Fig. 3b is an illustrative flowchart illustrating another process for depositing a metal fluoride coating on a glass substrate using combustion deposition in accordance with an example embodiment. The process of Fig. 3b is similar to the process of Fig. 3a. Thus, in step S300, a substrate (e.g., a glass substrate) having at least one surface to be coated is provided. However, unlike the process of Fig. 3a, in step S304', a single-source precursor to be combusted by a burner is introduced. The single-source precursor is alkaline earth metal and fluorine inclusive. In step S306', at least some of the single-source precursor is combusted to form a combusted material. In step S308, the substrate is provided in an area so that the substrate is heated sufficiently to allow the combusted materials to produce growths, directly or indirectly, on the substrate in forming the coating. As above, the combusted material may include at least some non-vaporized material (e.g., at least some particulate matter).

In certain example implementations of the processes of Figs. 3a or 3b, the process conditions include a flame temperature of between about 1000-1400°C, an air-to-propane ratio of about 15-30, and an air flow rate of between about 100-300 standard liters per minute.

Optionally, in one or more steps not shown, the opposing surface of the substrate also may be coated. Also optionally, the substrate may be wiped and/or washed, e.g., to remove excess particulate matter deposited thereon. A coating with a refractive index of 1.38 and low absorption is expected to provide a Tvis gain of greater than or equal to about 2.5% or 2.5% points, per side.

In certain example embodiments, magnesium fluoride (e.g., MgF₂ or other suitable stoichiometry) coatings may be made via combustion deposition. However, in certain example implementations, other metal fluoride coatings may be made using combustion deposition where, for example, the metal is an alkaline earth metal (e.g., a Group 2 metal). Thus, in certain example implementations, coatings of Ca-, Sr-, and BaF₂ (and suitable stoichiometries of the same) may be deposited via combustion deposition.

It will be appreciated that the metal inclusive organic precursors, fluorinating reagents, and/or single-source precursors identified above are provided by way of example. Any suitable stoichiometry similar to any of the precursors and/or reagents identified above may be used. Additionally, other metal fluorides may be deposited, other precursors may be used in connection with these and/or other metal fluoride depositions, the precursor delivery techniques may be altered, and/or other potential uses of such coatings may be possible.

Also, it will be appreciated that the techniques of the example embodiments described herein may be applied to a variety of products. That is, a variety of products potentially may use these and/or other AR films, depending in part on the level of transmission gain that is obtained. Such potential products include, for example, photovoltaic, green house, sports and roadway lighting, fireplace and oven doors, picture frame glass, etc. Non-AR products also may be produced.

The example embodiments described herein may be used in connection with other types of multiple layer AR coatings, as well. By way of example and without limitation, multiple reagents and/or precursors may be selected to provide coatings comprising multiple layers. The other layers may include the same and/or different materials.

Further disclosures are:
1. A method of forming a coating on a glass substrate using combustion deposition, the method comprising:
   providing a glass substrate having at least one surface to be coated;
   introducing an alkaline earth metal inclusive precursor and a fluorinating reagent to be combusted by a flame;
   combusting at least a portion of the precursor and at least a portion of the reagent to form a combusted material, the combusted material comprising non-vaporized material; and
   providing the glass substrate in an area so that the glass substrate is heated sufficiently to allow the combusted material to form the coating, directly or indirectly, on the glass substrate.
2. The method of embodiment 1, wherein the precursor is an organic, metal-inclusive precursor.
3. The method of embodiment 2, wherein the organic metal inclusive precursor is a magnesium inclusive precursor.
4. The method of embodiment 2, wherein the metal-inclusive precursor is [Me(OR)₂]ₓ, where Me is a Group 2 metal and R is a saturated organic group containing 1 to 5 carbon atoms.
5. The method of embodiment 4, wherein the magnesium inclusive precursor is at least one of a metal alkoxyalkoxide or Me(OROR')₂, metal acetoacetonate or Me(acac)₂, metal alkanoate or Me(OOCR)₂, fluorinated acetoacetonate or Me(acac^{F})₂, and suitable stoichiometries thereof.
6. The method of embodiment 3, wherein the magnesium inclusive precursor is a fluorinated acetoacetonate, the fluorinated acetoacetonate being tri- or hexafluoropentanedionates.
7. The method of embodiment 1, wherein the fluorinating reagent is an organic fluorinating reagent.
8. The method of embodiment 7, wherein the organic fluorinating reagent comprises at least one of hexafluoro benzene (C₆F₆ or other suitable stoichiometry) and trifluoro toluene, C₇H₅F₃ (as C₆H₅CF₃ or C₆H₂F₃CH₃, or other suitable stoichiometry)
9. The method of embodiment 7, wherein the organic fluorinating reagent is a fluourinated carboxylic acid or a fluorinated alcohol.
10. The method of embodiment 9, wherein the organic fluorinating reagent is a fluourinated carboxylic acid or acid anhydride comprising at least one of trifluoro acetic acid (CF₃COOH or other suitable stoichiometry), and trifluoro acetic anhydride.
11. The method of embodiment 9, wherein the organic fluorinating reagent is a fluorinated alcohol comprising (F₃C)₃COH (or other suitable stoichiometry).
12. The method of embodiment 1, wherein the fluorinating reagent is an inorganic fluorinating reagent.
13. The method of embodiment 12, wherein the inorganic fluorinating reagent comprises at least one of NF₃, SF₆, and suitable stoichiometries of the same.
14. The method of embodiment 1, wherein the coating is a magnesium fluoride inclusive coating that exhibits anti-reflective properties.
15. The method of embodiment 1, further comprising depositing at least one additional coating via combustion deposition on a second surface of the glass substrate.
16. A method of forming a coating on a glass substrate using combustion deposition, the method comprising:
   providing a glass substrate having at least one surface to be coated;
   introducing a single-source precursor to be combusted by a flame, the single-source precursor being alkaline earth metal and fluorine inclusive;
   combusting at least a portion of the precursor to form a combusted material, the combusted material comprising non-vaporized material; and
   providing the glass substrate in an area so that the glass substrate is heated sufficiently to allow the combusted material to form the coating, directly or indirectly, on the glass substrate,
   wherein the coating is a metal fluoride coating.
17. The method of embodiment 16, wherein the single-source precursor is a fluorinated acetoacetonate or Me(acac^{F})₂, where Me is a Group 2 metal.
18. The method of embodiment 17, wherein the fluorinated acetoacetonate is a tri- or hexafluoropentanedionate.
19. The method of embodiment 16, wherein the single-source precursor is a fluorinated metal alkoxide, alkanoate, or alkoxyalkoxide.
20. The method of embodiment 16, further comprising depositing at least one additional coating via combustion deposition on a second surface of the glass substrate.
21. A method of making a coated article including a combustion deposition deposited coating, the method comprising:
   providing a glass substrate having at least one surface to be coated;
   introducing an alkaline earth metal inclusive precursor and a fluorinating reagent to be combusted by a flame;
   combusting at least a portion of the precursor and at least a portion of the reagent to form a combusted material, the combusted material comprising non-vaporized material; and
   providing the glass substrate in an area so that the glass substrate is heated sufficiently to allow the combusted material to form the coating, directly or indirectly, on the glass substrate.
22. A method of making a coated article including a combustion deposition deposited coating, the method comprising:
   providing a glass substrate having at least one surface to be coated;
   introducing a single-source precursor to be combusted by a flame, the single-source precursor being alkaline earth metal and fluorine inclusive;
   combusting at least a portion of the precursor to form a combusted material, the combusted material comprising non-vaporized material; and
   providing the glass substrate in an area so that the glass substrate is heated sufficiently to allow the combusted material to form the coating, directly or indirectly, on the glass substrate,
   wherein the coating is a metal fluoride coating.
23. A coated article, comprising:
   a substrate; and
   a combustion deposition deposited alkaline earth metal fluoride coating supported by the substrate,
   wherein the alkaline earth metal fluoride coating includes at least one of magnesium, calcium, strontium, and barium, and
   wherein the coating is a single-layer anti-reflective coating.
24. The method of embodiment 3, wherein the magnesium inclusive precursor is a metal alkanoate, the metal alkanoate being methacrylate or 2-ethylhexanoate.

While the invention has been described in connection with what is presently considered to be the most practical and preferred embodiment, it is to be understood that the invention is not to be limited to the disclosed embodiment, but on the contrary, is intended to cover various modifications included within the scope of the appended claims.

## Claims

1. A method of forming a coated article using combustion deposition, the method comprising:
providing a glass substrate having at least one surface to be coated;
introducing a single-source precursor to be combusted by a flame, the single-source precursor being alkaline earth metal and fluorine inclusive;
combusting at least a portion of the precursor to form a combusted material, the combusted material comprising non-vaporized material; and
providing the glass substrate in an area so that the glass substrate is heated sufficiently to allow the combusted material to form the coating, directly or indirectly, on the glass substrate,
wherein the coating is a metal fluoride coating.

2. The method of claim 1, wherein the single-source precursor is a fluorinated acetoacetonate or Me(acac^{F})₂, where Me is a Group 2 metal.

3. The method of claim 1, wherein the single-source precursor is a fluorinated metal alkoxide, alkanoate, or alkoxyalkoxide.

## Patentansprüche

1. Ein Verfahren zum Herstellen eines beschichteten Gegenstands unter Verwendung von Verbrennungsablagerung, wobei das Verfahren umfasst:
Bereitstellen eines Glassubstrats, welches zumindest eine zu beschichtende Fläche aufweist;
Einführen eines Ein-Quellen-Vorprodukts, welches durch eine Flamme verbrannt werden soll, wobei das Ein-Quellen-Vorprodukt Erdalkalimetall- und Fluorbeinhaltend ist;
Verbrennen zumindest eines Teils des Vorprodukts, um ein verbranntes Material zu bilden, wobei das verbrannte Material nicht verdampftes Material umfasst; und
Bereitstellen des Glassubstrats in einem Bereich, so dass das Glassubstrat ausreichend aufgewärmt wird, um es dem verbrannten Material zu erlauben, die Beschichtung auf dem Glassubstrat, direkt oder indirekt zu bilden,
wobei die Beschichtung eine Metallfluorid-Beschichtung ist.

2. Verfahren nach Anspruch 1, wobei das Ein-Quellen-Vorprodukt ein fluoridiertes Acetoacetonat oder Me(acac^{F})₂ ist, wobei Me ein Metall der 2. Gruppe ist.

3. Verfahren nach Anspruch 1, wobei das Ein-Quellen-Vorprodukt ein fluoridiertes Metall-Alkoxid, -Alkanoat oder -Alkoxyalkoxid ist.

## Revendications

1. Procédé de formation d'un article revêtu, par utilisation d'un dépôt par combustion, le procédé comprenant :
la fourniture d'un substrat de verre ayant au moins une surface à revêtir ;
l'introduction d'un précurseur mono-source devant subir une combustion à la flamme, le précurseur mono-source étant un métal alcalino-terreux et du fluor, compris ;
la combustion d'au moins une partie du précurseur pour former un matériau brûlé, le matériau brûlé comprenant un matériau non vaporisé ; et
la fourniture du substrat de verre dans une zone de telle sorte que le substrat de verre soit suffisamment chauffé pour permettre au matériau brûlé de former le revêtement, directement ou indirectement, sur le substrat de verre,
le revêtement étant un revêtement de fluorure métallique.

2. Procédé selon la revendication 1, dans lequel le précurseur mono-source est un acétoacétonate fluoré, ou Me(acac^{F})₂, Me étant un métal du Groupe 2.

3. Procédé selon la revendication 1, dans lequel le précurseur mono-source est un alcoxyde, un alcanoate ou un alcoxyalcoxyde métallique fluoré.
